# EUROPEAN PATENT SPECIFICATION

(11) **EP 1 901 597 B1**
(45) Date of publication and mention of the grant of the patent: **24.06.2009**
(21) Application number: 07253649.3
(22) Date of filing: 13.09.2007
(51) Int. Cl.: H05K 5/02

(54) **Plasma display module**
Plasmaanzeigemodul
Module d'affichage à plasma

(30) Priority: 13.09.2006 KR 20060088682
(43) Date of publication of application: 19.03.2008
(73) Proprietor: Samsung SDI Co., Ltd., Suwon-si, Gyeonggi-do (KR)
(72) Inventor: Bang, Won-Kyu, Seoul 137-875 (KR); Kim, Myoung-Kon, Seoul 137-875 (KR)
(74) Representative: Mounteney, Simon James

(56) References cited:
- US-A1- 2005 031 492
- US-A1- 2005 116 644
- US-A1- 2005 174 726
- US-A1- 2005 212 982
- US-A1- 2006 152 909

## Description

The present invention relates to a plasma display module, and more particularly, to a plasma display module which prevents damage of an integrated circuit chip of a signal transmission unit by preventing a cover plate from being inclined during an assembling process of the cover plate.

Plasma display panels (PDP) which come into the spotlight for replacing conventional cathode ray tube (CRT) display apparatuses, are flat display devices in which a discharge gas is sealed between two substrates in which a plurality of electrodes are formed, and then a discharge voltage is applied, and a phosphor layer formed in a predetermined pattern is excited by ultraviolet rays generated in a discharge processor, the phosphor layer then emits visible rays, and desired images are obtained.

A plasma display device includes a plasma display module. In general, the plasma display module includes a plasma display panel (PDP) and a driving device for driving the plasma display panel (PDP).

The driving device includes a circuit element and a circuit board on which the circuit element is disposed. The circuit board is electrically connected to the PDP by using the signal transmission unit. A plurality of wires extend in the lengthwise direction of the signal transmission unit. An integrated circuit chip is installed in part of a signal transmission unit.

The integrated circuit chip installed in the signal transmission unit is disposed on a flange positioned at an edge of a chassis or is disposed to a reinforcement installed on the chassis. A large amount of heat is generated from the integrated circuit chip when the PDP is driven.

Thus, a conventional plasma display module includes a cover plate installed to be closely adhered to the integrated circuit chip, thereby effectively dissipating heat generated from the integrated circuit chip.

The cover plate is installed on the chassis using a boss or the like. Since the cover plate is installed to be closely adhered to the integrated circuit chip, a portion of the cover plate that is closely adhered to the integrated circuit chip must be installed in parallel to the integrated circuit chip. This is because, when the portion of the cover plate that is closely adhered to the integrated circuit chip is inclined to the integrated circuit chip, the integrated circuit chip is asymmetrically pressed by the cover plate and may be damaged by excessive stress concentration.

US 2005/011664 discloses an arrangement in which a cover plate is in contact with an electronic device.

US 2006/0152909, over which the independent claim is characterised, discloses a known plasma display apparatus. Arrangements for positioning parts relative to each other are known from US 2005/0031492, which discloses a system for positioning a cover relative to a chassis in the context of a conveyance device, and from US 2005/0212982, which discloses a way of positioning a front cabinet, a flat display panel and a chassis frame of a display apparatus relative to each other.

The present invention provides a plasma display module which prevents damage of an integrated circuit chip of a signal transmission unit by preventing a cover plate from being inclined during an assembling process of the cover plate.

According to an aspect of the present invention, there is provided a plasma display module as set out in Claim 1. Preferred features of this aspect are set out in Claims 2 to 13.

A more complete appreciation of the invention and many of the attendant advantages thereof, will be readily apparent as the same becomes better understood by reference to the following detailed description when considered in conjunction with the accompanying drawings in which like reference symbols indicate the same or similar components, wherein:
FIG. 1 is a schematic view illustrating the case where a conventional cover plate is inclined with respect to an integrated circuit chip of a signal transmission unit so that stress is concentrated on portion A of the integrated circuit chip;
FIG. 2 is a schematic exploded perspective view of a plasma display module according to an embodiment of the present invention;
FIG. 3 is an exploded perspective view illustrating an enlarged chassis portion of FIG. 2; and
FIG. 4 is a schematic enlarged cross-sectional view taken along line IV-IV of FIG. 3.

The present invention will now be described more fully with reference to the accompanying drawings, in which exemplary embodiments of the invention are shown.

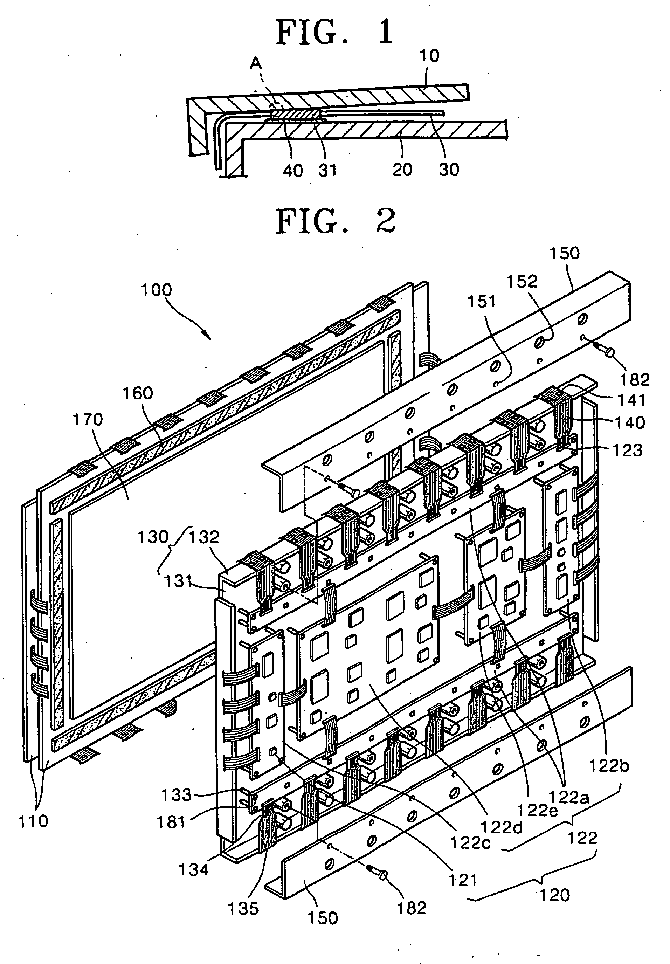

FIG. 1 is a schematic view illustrating the case where a cover plate is inclined with respect to an integrated circuit chip of a signal transmission unit so that stress is concentrated on portion A of the integrated circuit chip 31.

As illustrated in FIG. 1, a cover plate 10 is installed on a chassis 20, and an integrated circuit chip 31 of a signal transmission unit 30 is attached to the chassis 20 using an adhesive 40.

Here, the cover plate 10 is installed to be inclined with respect to the integrated circuit chip 31 so that portion A of the integrated circuit chip 31 is excessively pressed by the cover plate 10 and stress is concentrated on portion A. When stress is excessively concentrated in this way, the integrated circuit chip 30 may be damaged so that an increase in a defective rate occur increasing manufacturing costs.

Therefore, a worker must perform a variety of processes such as checking the state where screws of a bolt and a boss for fixing the cover plate are well engaged with each other so as to prevent the cover plate from being inclined with respect to the integrated circuit chip during a process of installing the cover plate, checking other factors for generating inclination of the cover plate, and checking an inclination degree of the finally-assembled cover plate. Thus, the time necessary to manufacture the device is increased accordingly and manufacturing costs increase.

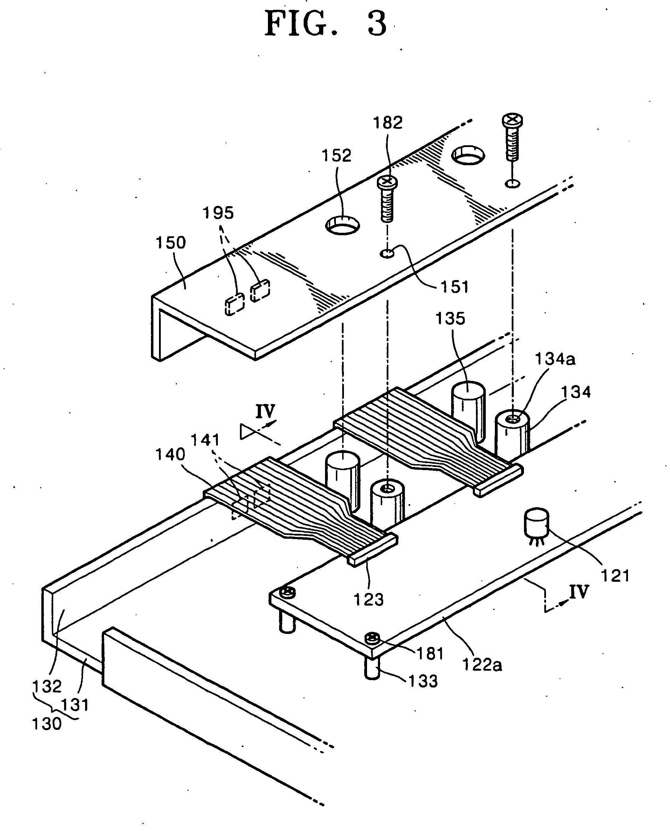

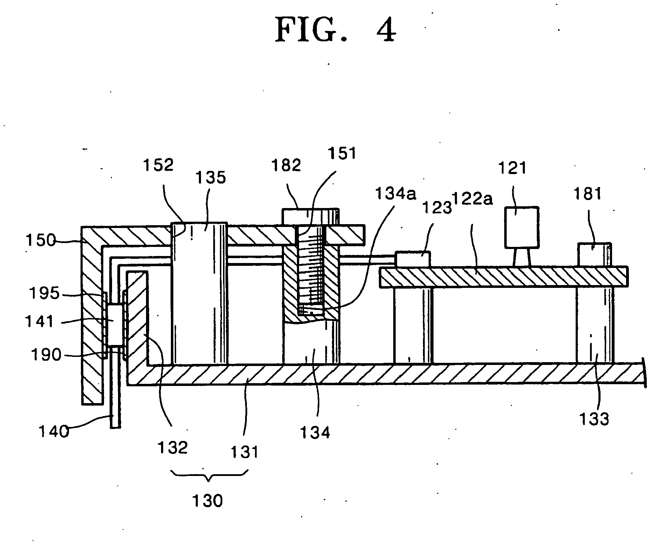

FIG. 2 is a schematic exploded perspective view of a plasma display module according to an embodiment of the present invention, FIG. 3 is an exploded perspective view illustrating an enlarged chassis portion of FIG. 2, and FIG. 4 is a schematic enlarged cross-sectional view taken along line IV-IV of FIG. 3.

As illustrated in FIG. 2, the plasma display module 100 according to an embodiment of the present invention comprises a plasma display panel (PDP) 110 for realizing an image, a driving device 120, a chassis 130, a signal transmission unit 140, and a cover plate 150.

The PDP 110 is installed at the chassis 130. The PDP 110 and the chassis 130 are combined with each other using a double-faced adhesive 160 attached to the rear side of the PDP 110. A double-faced tape may be used as the double-faced adhesive 160.

A panel heat-dissipation sheet 170 having high thermal conductivity is interposed between the PDP 110 and the chassis 130 so that heat generated during an operation of the PDP 110 can be prevented from being locally concentrated and heat-dissipation can be easily performed.

The driving device 120 comprises a circuit element 121 and a circuit board 122.

The circuit board 122 comprises an address electrode buffer circuit board 122a, an X-electrode driving circuit board 122b, a Y-electrode driving circuit board 122c, a power supply board 122d, and a logic control board 122e. A plurality of circuit elements 121 are disposed on the circuit board 122. In the present embodiment, the address electrode buffer circuit board 122a will be described.

The address electrode buffer circuit board 122a is installed on a chassis base 131 by using a circuit board installation boss 133 and a circuit board installation bolt 181.

A connector 123 is disposed on the address electrode buffer circuit board 122a so as to be electrically connected to the signal transmission unit 140.

The chassis 130 is formed of aluminum and comprises a chassis base 131 and at least one chassis flange 132.

The chassis 130 according to the present embodiment is formed of aluminum but the present invention is not limited to this. That is, there is no specific limitation in a material used in forming the chassis 130 according to the present invention and for example, the chassis 130 may be formed of iron or synthetic resin or the like.

The chassis base 131 constitutes the greater part of the chassis 130. A plurality of circuit board installation bosses 133, a plurality of cover plate installation bosses 134, and a plurality of guide bosses 135 are formed on the chassis base 131.

Here, the circuit board installation bosses 133 are used to install (mount) the circuit board 122 and correspond to a portion of the chassis base 131 in which the circuit board 122 is to be installed.

The cover plate installation bosses 134 are used to install (mount) the cover plate 150 and are formed at edges of the chassis base 131. Each of the circuit board installation bosses 133 and each of the cover plate installation bosses 134 comprise a threaded tap hole and can be combined with the circuit board installation bolt 181 and the cover plate installation bolt 182, respectively.

The guide bosses 135, used to prevent inclination of the cover plate 150 and to help installation of the cover plate 150, are formed near edges of the chassis base 131 adjacent to flanges 132, and may be adjacent to and paired with the cover plate installation bosses 134.

Each of the guide bosses 135 is formed to have a height at which each guide boss 135 is inserted in a guide hole 152 of the cover plate 150. In this embodiment, each guide boss 135 does not comprise a threaded tap hole, unlike the circuit board installation bosses 133 and the cover plate installation bosses 134.

The chassis flange 132 is positioned at an edge of the chassis 130 and is bent to a similar height to the height of the circuit board 122.

A cable, such as a tape carrier package (TCP) or a chip on film (COF), is used as the signal transmission unit 140 for electrically connecting the PDP 110 and the address electrode buffer circuit board 122a.

The signal transmission unit 140 for transmitting an address signal passes a side of the chassis flange 132. One end of the signal transmission unit 140 is connected to the connector 123 installed on the address electrode buffer circuit board 122a, and the other end thereof passes the chassis flange 132 and is connected to the PDP 110.

Meanwhile, an integrated circuit chip 141 is installed in the signal transmission unit 140. The integrated circuit chip 141 controls an electrical signal that flows through the signal transmission unit 140.

The integrated circuit chip 141 is installed on the chassis flange 132 of the chassis 130.

In the present embodiment, the integrated circuit chip 141 is installed on the chassis flange 132 but the present invention is not limited to this. That is, according to embodiments of the present invention, when the chassis 130 comprises a reinforcement for reinforcing rigidity of the chassis base 131, the integrated circuit chip 141 may be installed on the reinforcement. In the present case, the chassis flange 132 provides reinforcement and rigidity to the chassis base 131.

A thermal grease 190 is interposed between the integrated circuit chip 141 and the chassis flange 132.

In the present embodiment, the thermal grease 190 is installed between the integrated circuit chip 141 and the chassis flange 132. However, the present invention is not limited to this. That is, according to embodiments of the present invention, the integrated circuit chip 141 may be directly in contact with the chassis flange 132 in the state where there is no thermal conduction medium such as the thermal grease 190, or a chip heat-dissipation sheet formed of a material having high thermal conductivity may be interposed between the integrated circuit chip 141 and the chassis flange 132.

The cover plate 150 is formed to have a 'L' shape having a curved inner angle of 90 degrees and includes aluminum and iron or the like, having high thermal conductivity. The cover plate 150 protects the signal transmission unit 140 and the integrated circuit chip 141 and dissipates heat generated in the integrated circuit chip 141.

The cover plate 150 is installed on the cover plate installation boss 134 formed on the chassis base 131. To this end, an installation hole 151 is formed in the cover plate 150. The size of the installation hole 151 is smaller than the size of an upper end of the cover plate installation boss 134 so that the cover plate 150 is placed above the cover plate installation boss 134 and then is secured and removably mounted by the cover plate installation bolt 182.

That is, a worker passes the cover plate installation bolt 182 through the installation hole 151 and combines the cover plate installation bolt 182 with a threaded tap hole 134a of the cover plate installation boss 134 so that the cover plate 150 can be installed on the cover plate installation boss 134.

In addition, the guide hole 152 is formed in the cover plate 150 to be adjacent to the installation hole 151.

The guide hole 152 is formed in such a way that the guide boss 135 is inserted in the guide hole 152. The guide hole 152 is preferably formed through the cover plate 150.

The size of the guide hole 152 is formed in such a way that the guide hole 152 is fitted to the guide boss 135. Here, fitting of the guide hole 152 and the guide boss 135 may be slide fit, or tight or interference fit.

Since the height of an inner circumferential surface of the guide hole 152 is the same as the thickness of the cover plate 150, when the guide hole 152 is inserted on the guide boss 135, the inner circumferential surface of the guide hole 152 contacts the guide boss 135 and serves as a guide. Then, an inclination for installing the cover plate 150 can be adjusted within an allowable limit desired by a designer.

As such, a portion of the cover plate 150 in which the installation hole 151 and the guide hole 152 are formed can be in parallel to the chassis base 131 and a portion of the cover plate 150 which corresponds to the integrated circuit chip 141 can be in parallel to the integrated circuit chip 141 and the chassis flange 132.

Through the above-described structure, since the cover plate 150 is not inclined with respect to one surface of the integrated circuit chip 141 and is in parallel thereto, force, if any, that acts on the integrated circuit chip 141 by the cover plate 150 is uniform. Then, partial stress concentration can be prevented so that damage of the integrated circuit chip 141 can be prevented.

According to the present embodiment, the guide hole 152 is formed to have a circular shape and the cross-section of the guide boss 135 is also formed to have a circular shape. However, the present invention is not limited to this. That is, the shapes of the guide hole and the guide boss according to embodiments of the present invention are not limited only if the guide hole and the guide boss are inserted in each other, allow the position of the cover plate to be in parallel to the integrated circuit chip and damage of the integrated circuit chip is prevented. For example, the guide hole may be formed to have a hexagonal shape and the cross-section of the guide boss may also be formed to have a hexagonal shape accordingly.

A chip heat-dissipation sheet 195 formed of a material having high thermal conductivity is interposed between the integrated circuit chip 141 and the cover plate 150. The chip heat-dissipation sheet 195 transmits heat generated in the integrated circuit chip 141 to the cover plate 150.

In the present embodiment, the chip heat-dissipation sheet 195 is installed between the integrated circuit chip 141 and the cover plate 150. However, embodiments of the present invention are not limited to this. That is, according to embodiments of the present invention, the integrated circuit chip 141 may be directly in contact with the cover plate 150 in the state where there is no thermal conduction medium such as the chip heat-dissipation sheet 195 or a thermal grease having high thermal conductivity may be interposed between the integrated circuit chip 141 and the cover plate 150.

The worker can install the cover plate 150 according to embodiments of the present embodiment using the following method.

That is, the user applies the thermal grease 190 on the chassis flange 132 and properly disposes the signal transmission unit 140 so that the integrated circuit chip 141 can be positioned on the applied thermal grease 190.

Next, the worker places the chip heat-dissipation sheet 195 between the integrated circuit chip 141 and the cover plate 150 and then, installs the cover plate 150 on the cover plate installation boss 134.

In this case, the worker inserts the guide hole 152 of the cover plate 150 on the guide boss 135, passes the cover plate installation bolt 182 through the installation hole 151, and combines the cover plate installation bolt 182 with a threaded tap hole 134a of the cover plate installation boss 134. As such, the cover plate 150 is not inclined with respect to the integrated circuit chip 141 and is precisely and rapidly installed as designed so that damage of the integrated circuit chip 141 can be prevented.

An operation of operating the plasma display module 100 according to embodiments of the present embodiment and a dissipation path of heat generated in the integrated circuit chip 141 will now be described.

When the user operates the plasma display module 100, the driving device 120 is driven and a voltage is applied to the PDP 110.

When the voltage is applied to the PDP 110, an address discharge and a sustain discharge occur, the energy level of the excited discharge gas during the sustain discharge is reduced and UV rays are emitted. The UV rays excite phosphor of a phosphor layer applied within discharge cells. The energy level of the excited phosphor is reduced, visible rays are emitted, and the visible rays are emitted so that an image that can be recognized by the user can be formed.

In this case, a large amount of heat is generated in the integrated circuit chip 141 installed in the signal transmission unit 140. Part of the heat is transmitted to the chassis flange 132 via the thermal grease 190 and other part of the heat is transmitted to the cover plate 150 via the chip heat-dissipation sheet 195.

The heat generated in the integrated circuit chip 141 and transmitted to the cover plate 150 is directly dissipated by convection heat transmission through the air that contacts the cover plate 150.

As described above, in the plasma display module 100 according to embodiments of the present invention, when the cover plate 150 is installed, the guide boss 135 and the guide hole 152 are assembled such that the cover plate 150 is prevented from being inclined with respect to the integrated circuit chip 141 and damage of the integrated circuit chip 141 is prevented.

In addition, according to embodiments of the present invention, a process in which the worker checks the state where screws of the cover plate installation bolt 182 and the cover plate installation boss 134 are well engaged with each other and checks inclination for installing the cover plate 150 can be omitted such that the number of processes required to install the cover plate 150 and an assembling time are reduced.

As described above, the plasma display module according to the present invention comprises the guide boss and the guide hole such that inclination of the cover plate with respect to the integrated circuit chip is prevented and the cover plate is rapidly installed. As such, damage of the integrated circuit chip of the signal transmission unit is prevented, and the number of processes required to install the cover plate and a working time are reduced.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A plasma display module comprising:
a plasma display panel (110), PDP, for realizing an image;
a driving device (120) for driving the PDP;
a chassis (130) for supporting the PDP (110) and the driving device (120);
a signal transmission unit (140) arranged to electrically connect the PDP (110) and the driving device (120); and
a cover plate (150);
**CHARACTERISED BY**:
the signal transmission unit (140) including an integrated circuit chip (141);
the cover plate (150) being installed to face the integrated circuit chip (141);
the chassis (130) including at least one guide boss (135); and
the integrated circuit chip (141) being in heat conducting contact with the cover plate (150) so that heat generated in the integrated circuit chip (141) can be transmitted to the cover plate (150);
wherein said cover plate (150) includes at least one guide hole (152) having an inner circumferential surface, the guide boss (135) inserted into the guide hole ( 152),
wherein said inner circumferential surface contacts the guide boss (135) and guides the guide boss (135) so as to prevent the cover plate (150) from being inclined with respect to the integrated circuit chip (141).

2. A plasma display module according to claim 1, wherein the driving device (120) comprises a circuit element (121) and a circuit board (122) on which the circuit element (121) is disposed.

3. A plasma display module according to claim 1 or 2, wherein the signal transmission unit (140) is a tape carrier package or a chip on film.

4. A plasma display module according to any one of claims 1 to 3, wherein the integrated circuit chip (141) is in contact with a flange portion (132) of said chassis (130).

5. A plasma display module according to claim 4, wherein a chip heat-dissipation sheet is interposed between the integrated circuit chip (141) and the flange portion (132) of said chassis (130).

6. A plasma display module according to claim 4, wherein a thermal grease (190) is interposed between the integrated circuit chip (141) and the flange portion (132) of said chassis (130).

7. A plasma display module according to any one of claims 1 to 6, wherein a chip heat-dissipation sheet (195) is interposed between the integrated circuit chip (141) and the cover plate (150).

8. A plasma display module according to any one of claims 1 to 7, wherein a thermal grease is interposed between the integrated circuit chip (141) and the cover plate (150).

9. A plasma display module according to any one of the preceding claims, wherein at least one cover plate installation boss (134) for installing the cover plate (150) is formed on the chassis (130), and at least one installation hole (151) corresponding to the cover plate installation boss (134) is formed in the cover plate (150).

10. A plasma display module according to claim 9, wherein the cover plate (150) is securely mounted to the cover plate installation boss (134) using a cover plate installation bolt (182).

11. A plasma display module according to any one of claims 1 to 8, which said chassis (130) includes at least one pair of a said guide boss (135) and an adjacent cover plate installation boss (135), and
said cover plate (150) includes at least one installation hole (151) through which a cover plate installation bolt (182) is inserted to connect with a said cover plate installation boss (134).

12. A plasma display module according to claim 11, wherein said chassis (130) comprises a plurality of pairs of guide bosses (135) and adjacent cover plate installation bosses (134).

13. A plasma display module according to claim 11 or 12, wherein said chassis (130) comprises a first plurality of pairs of guide bosses (135) and adjacent cover plate installation bosses (134) on one end of said chassis (130), and a second plurality of pairs of guide bosses (135) and adjacent cover plate installation bosses (134) on an opposite end of said chassis (130).

## Patentansprüche

1. Plasmaanzeigemodul, das aufweist:
einen Plasmabildschirm (110) PDP für das Realisieren eines Bildes;
eine Antriebsvorrichtung (120) für den Antrieb des PDPs;
ein Chassis (130) für das Tragen des PDPs (110) und der Antriebsvorrichtung (120);
eine Signalübertragungseinheit (140), die angeordnet ist, um den PDP (110) und die Antriebsvorrichtung (120) elektrisch zu verbinden; und
eine Abdeckplatte (150);
**dadurch gekennzeichnet, dass**
die Signalübertragungseinheit (140) einen integrierten Schaltungschip (141) umfasst;
die Abdeckplatte (150) so installiert ist, dass sie zum integrierten Schaltungschip (141) hin liegt;
das Chassis (130) mindestens einen Führungsvorsprung (135) umfasst; und
der integrierte Schaltungschip (141) in wärmeleitendem Kontakt mit der Abdeckplatte (150) ist, so dass die im integrierten Schaltungschip (141) erzeugte Wärme auf die Abdeckplatte (150) übertragen werden kann;
wobei die Abdeckplatte (150) mindestens ein Führungsloch (152) mit einer inneren Umfangsfläche umfasst, wobei der Führungsvorsprung (135) in das Führungsloch (152) eingesetzt wird,
wobei die innere Umfangsfläche den Führungsvorsprung (135) kontaktiert und den Führungsvorsprung (135) so führt, dass verhindert wird, dass die Abdeckplatte (150) mit Bezugnahme auf den integrierten Schaltungschip (141) geneigt wird.

2. Plasmaanzeigemodul nach Anspruch 1, bei dem die Antriebsvorrichtung (120) ein Schaltkreiselement (121) und eine Leiterplatte (122) aufweist, auf der das Schaltkreiselement (121) angeordnet ist.

3. Plasmaanzeigemodul nach Anspruch 1 oder 2, bei dem die Signalübertragungseinheit (140) eine Bandträgerbaueinheit oder ein Chip-on-Film ist.

4. Plasmaanzeigemodul nach einem der Ansprüche 1 bis 3, bei dem der integrierte Schaltungschip (141) in Kontakt mit einem Flanschabschnitt (132) des Chassis (130) ist.

5. Plasmaanzeigemodul nach Anspruch 4, bei dem eine Chip-Wärmeableitungsplatte zwischen dem integrierten Schaltungschip (141) und dem Flanschabschnitt (132) des Chassis (130) angeordnet ist.

6. Plasmaanzeigemodul nach Anspruch 4, bei dem eine Wärmeleitpaste (190) zwischen dem integrierten Schaltungschip (141) und dem Flanschabschnitt (132) des Chassis (130) angeordnet ist.

7. Plasmaanzeigemodul nach einem der Ansprüche 1 bis 6, bei dem eine Chip-Wärmeableitungsplatte (195) zwischen dem integrierten Schaltungschip (141) und der Abdeckplatte (150) angeordnet ist.

8. Plasmaanzeigemodul nach einem der Ansprüche 1 bis 7, bei dem eine Wärmeleitpaste zwischen dem integrierten Schaltungschip (141) und der Abdeckplatte (150) angeordnet ist.

9. Plasmaanzeigemodul nach einem der vorhergehenden Ansprüche, bei dem mindestens ein Abdeckplattenmontagevorsprung (134) für das Montieren der Abdeckplatte (150) am Chassis (130) gebildet wird und mindestens ein Montageloch (151) entsprechend dem Abdeckplattenmontagevorsprung (134) in der Abdeckplatte (150) gebildet wird.

10. Plasmaanzeigemodul nach Anspruch 9, bei dem die Abdeckplatte (150) sicher am Abdeckplattenmontagevorsprung (134) unter Verwendung einer Abdeckplattenmontageschraube (182) montiert wird.

11. Plasmaanzeigemodul nach einem der Ansprüche 1 bis 8, bei dem das Chassis (130) mindestens ein Paar eines Führungsvorsprunges (135) und eines benachbarten Abdeckplattenmontagevorsprunges (134) umfasst, und
die Abdeckplatte (150) mindestens ein Montageloch (151) umfasst, durch das eine Abdeckplattenmontageschraube (182) eingesetzt wird, um eine Verbindung mit dem Abdeckplattenmontagevorsprung (134) zu bewirken.

12. Plasmaanzeigemodul nach Anspruch 11, bei dem das Chassis (130) eine Vielzahl von Paaren von Führungsvorsprüngen (135) und benachbarten Abdeckplattenmontagevorsprüngen (134) aufweist.

13. Plasmaanzeigemodul nach Anspruch 11 oder 12, bei dem das Chassis (130) eine erste Vielzahl von Paaren von Führungsvorsprüngen (135) und benachbarten Abdeckplattenmontagevorsprüngen (134) an einem Ende des Chassis (130) und eine zweite Vielzahl von Paaren von Führungsvorsprüngen (135) und benachbarten Abdeckplattenmontagevorsprüngen (134) an einem entgegengesetzten Ende des Chassis (130) aufweist.

## Revendications

1. Module d'affichage à plasma, comprenant:
un panneau d'affichage à plasma (110), PDP, pour réaliser une image ;
un dispositif d'entraînement (130) pour entraîner le PDP ;
un châssis (130) pour supporter le PDP (110) et le dispositif d'entraînement (120) ;
une unité de transmission de signaux (140) agencée de sorte à assurer la connexion électrique du PDP (110) et du dispositif d'entraînement (120) ; et
une plaque de couverture (150) ;
**caractérisé en ce que**
l'unité de transmission de signaux (140) englobe une puce de circuit intégré (141) ; la plaque de couverture (150) étant installée de sorte à faire face à la puce de circuit intégré (141) ;
le châssis (130) englobe au moins un bossage de guidage (135) ; et
la puce de circuit intégré (141) est en contact à conduction thermique avec la plaque de couverture (150), de sorte que la chaleur produite dans la puce de circuit intégré (141) peut être transmise vers la plaque de couverture (150) ;
ladite plaque de couverture (150) englobant au moins un trou de guidage (152), comportant une surface circonférentielle interne, le bossage de guidage (135) étant inséré dans le trou de guidage (152) ;
ladite surface circonférentielle interne contactant le bossage de guidage (135) et guidant le bossage de guidage (135) de sorte à empêcher une inclinaison de la plaque de couverture (150) par rapport à la puce de circuit intégré (141).

2. Module d'affichage à plasma selon la revendication 1, dans lequel le dispositif d'entraînement (120) comprend un élément de circuit (121) et une carte de circuit (122) sur laquelle l'élément de circuit (121) est agencé.

3. Module d'affichage à plasma selon les revendications 1 ou 2, dans lequel l'unité de transmission de signaux (140) est un assemblage porteur de bande ou une puce sur film.

4. Module d'affichage à plasma selon l'une quelconque des revendications 1 à 3, dans lequel la puce de circuit intégré (141) est en contact avec une partie de bride (132) dudit châssis (130).

5. Module d'affichage à plasma selon la revendication 4, dans lequel une feuille de dissipation de la chaleur de la puce est agencée entre la puce de circuit intégré (141) et la partie de bride (132) dudit châssis (130).

6. Module d'affichage à plasma selon la revendication 4, dans lequel une pâte thermoconductible (190) est agencée entre la puce de circuit intégré (141) et la partie de bride (132) dudit châssis (130).

7. Module d'affichage à plasma selon l'une quelconque des revendications 1 à 6, dans lequel une feuille de dissipation de la chaleur de la puce (195) est agencée entre la puce de circuit intégré (141) et la plaque de couverture (150).

8. Module d'affichage à plasma selon l'une quelconque des revendications 1 à 7, dans lequel une pâte thermoconductible est agencée entre la puce de circuit intégré (141) et la plaque de couverture (150).

9. Module d'affichage à plasma selon l'une quelconque des revendications précédentes, dans lequel au moins un bossage d'installation de la plaque de couverture (134), pour installer la plaque de couverture (150), est formé sur le châssis (130), au moins un trou d'installation (151) correspondant au bossage d'installation de la plaque de couverture (134) étant formé dans la plaque de couverture (150).

10. Module d'affichage à plasma selon la revendication 9, dans lequel la plaque de couverture (150) est solidement montée sur le bossage d'installation de la plaque de couverture (134) par l'intermédiaire d'un boulon d'installation de la plaque de couverture (182).

11. Module d'affichage à plasma selon l'une quelconque des revendications 1 à 8, dans lequel ledit châssis (130) englobe au moins une paire d'un dit bossage de guidage (135) et d'un bossage d'installation de la plaque de couverture adjacent (134) ; et
ladite plaque de couverture (150) englobant au moins un trou d'installation (151) à travers lequel est inséré un boulon d'installation de la plaque de couverture (182) en vue de la connexion à un dit bossage d'installation de la plaque de couverture (134).

12. Module d'affichage à plasma selon la revendication 11, dans lequel ledit châssis (130) comprend plusieurs paires de bossages de guidage (135) et de bossages d'installation de la plaque de couverture adjacents (134).

13. Module d'affichage à plasma selon les revendications 11 ou 12, dans lequel ledit châssis (130) comprend une première pluralité de paires de bossages de guidage (135) et de bossages d'installation de la plaque de couverture adjacents (134) sur une extrémité dudit châssis (130) et une deuxième pluralité de paires de bossages de guidage (135) et de bossages d'installation de la plaque de couverture adjacents (134) sur une extrémité opposée dudit châssis (130).
